# EUROPÄISCHE PATENTSCHRIFT

(11) **EP 0 927 507 B1**
(45) Veröffentlichungstag und Bekanntmachung des Hinweises auf die Patenterteilung: **08.08.2007**
(21) Anmeldenummer: 98942560.8
(22) Anmeldetag: 16.07.1998
(51) Int. Cl.: H05K 3/18, C23C 18/16, C23C 18/20

(54) **LEITERBAHNSTRUKTUREN AUF EINEM NICHTLEITENDEN TRÄGERMATERIAL, INSBESONDERE FEINE LEITERBAHNSTRUKTUREN UND VERFAHREN ZU IHRER HERSTELLUNG**
CONDUCTING PATH STRUCTURES SITUATED ON A NON-CONDUCTIVE SUPPORT MATERIAL, ESPECIALLY FINE CONDUCTING PATH STRUCTURES AND METHOD FOR PRODUCING SAME
STRUCTURES DE TRACES CONDUCTEURS SITUEES SUR UN MATERIAU SUPPORT NON CONDUCTEUR, NOTAMMENT FINES STRUCTURES DE TRACES CONDUCTEURS ET PROCEDE PERMETTANT DE LES PRODUIRE

(30) Priorität: 22.07.1997 DE 19731346
(43) Veröffentlichungstag der Anmeldung: 07.07.1999
(73) Patentinhaber: LPKF Laser & Electronics Aktiengesellschaft, 30827 Garbsen (DE)
(72) Erfinder: Naundorf, Gerhard, Prof. Dr., 32657 Lemgo (DE); Wissbrock, Horst, Prof. Dr., 32760 Delmond (DE)
(74) Vertreter: Scheffler, Jörg
(86) Internationale Anmeldenummer: PCT/EP1998/004413
(87) Internationale Veröffentlichungsnummer: WO 1999/005895

(56) Entgegenhaltungen:
- EP-A- 0 277 325
- US-A- 3 546 011
- US-A- 5 405 656
- PATENT ABSTRACTS OF JAPAN vol. 10, no. 335 (C-384), 13. November 1986 & JP 61 141774 A (SUMITOMO BAKELITE CO), 28. Juni 1986
- PATENT ABSTRACTS OF JAPAN vol. 17, no. 328 (E-1385), 22. Juni 1993 & JP 05 037129 A (HITACHI AIC ), 12. Februar 1993
- J. GANZ ET AL.: "LAD - Ein neuartiges lasergestütztes Beschichtungsverfahren für Feinstleitermetallisierungen" GALVANOTECHNIK., Bd. 81, Nr. 10, Oktober 1990, Seiten 3661-3668, XP002085825 SAULGAU/WURTT DE in der Anmeldung erwähnt

## Beschreibung

Die Erfindung betrifft ein Verfahren zur Herstellung der Leiterbahnstrukturen, gemäß dem Oberbegriff des Anspruchs 1.

Aus der US 5 404 656 A ist ein Verfahren bekannt, bei dem eine Substratoberfläche mit einer Lösung eines Schwermetallkomplexes, beispielsweise Palladium mit einem organischen Komplexbildner wie EDTA, überschichtet und bestrahlt wird, so dass sich durch photokatalytische Reduktion Metallkeime abscheiden, auf welche danach stromlos eine Metallisierungsschicht aufgebracht wird. Dabei enthält die Schwermetallbasis im Bereich der Leiterbahnstrukturen durch Aufbrechen eines organischen nichtleitenden Schwermetallkomplexes gebildete Schwermetallkeime.

Die EP 02 77 325 A1 offenbart Leiterbahnstrukturen auf einem nichtleitenden Trägermaterial, beispielsweise Polyethersulfon, die aus einer schwermetallhaltigen Basis und einer auf diese aufgebrachten Metallisierungsschicht bestehen. Die schwermetallhaltige Basis enthält im Bereich der Leiterbahnstrukturen Metallpartikel. Das Trägermaterial enthält mikroporöse Trägerpartikel an die die Metallpartikel gebunden sind.

Durch den Sonderdruck "LAD - Ein neuartiges lasergestütztes Beschichtungsverfahren für Feinstleitermetallisierungen" aus Heft Nummer 10, Band 81 (1990) der Fachzeitschrift "Galvanotechnik" ist es bekannt geworden, zur Herstellung von Feinstleiterstrukturen von deutlich unter 100 mm auf einem nichtleitenden Trägermaterial vollflächig Pd-Acetat aus einer Lösung als dünnen Film aufzubringen. Durch eine nachfolgende Laserbelichtung mittels eines Excimerlasers mit einer Wellenlänge von 248 nm sollen dann im Bereich der zu erzeugenden Leiterbahnstrukturen Metallatome als Keime für eine nachfolgende stromlose Metallisierung freigesetzt werden. Vor der Metallisierung ist es jedoch erforderlich, einen Spülprozeß zur Entfernung der unzersetzten Bereiche des auf das Trägermaterial aufgebrachten metallhaltigen Filmes durchzuführen. Der Qualität dieses Spülprozesses kommt dabei eine entscheidende Rolle für die Vermeidung von Wildwuchsproblemen bei der nachfolgenden stromlosen Metallisierung zu. Im übrigen hat es sich gezeigt, daß mittels des beschriebenen Verfahrens keine ausreichende Haftfestigkeit der abgeschiedenen metallischen Leiterbahnen erzielbar ist.

Aufgabe der Erfindung ist es, ein sicheres Verfahren zur Herstellung der Leiterbahnstrukturen zu schaffen, das volladditiv durch selektive Oberflächenaktivierung und reduktive Kupferabscheidung eine feine Strukturierung ermöglicht.

Diese Aufgabe wird durch die Merkmale des Anspruchs 1 gelöst. Die weiteren Ausgestaltungen der Erfindung sind den jeweils zugehörigen Unteransprüchen zu entnehmen.

Da die schwermetallhaltige Basis des Trägermaterials im Bereich der Leiterbahnstrukturen Schwermetallkeime enthält, die durch Aufbrechen eines elektrisch nichtleitenden, auf eine mikroporöse Oberfläche des Trägermaterials aufgebrachten organischen Schwermetallkomplexes entstanden sind, kann eine Metallisierung erfolgen, ohne daß es erforderlich ist, um Wildwuchsprobleme zu vermeiden, die unbehandelten Bereiche der schwermetallhaltigen Basis vorher zu entfernen.

Zusätzlich wird eine hervorragende Haftfestigkeit der abgeschiedenen metallischen Leiterbahnen erzielt, da das Trägermaterial mikroporöse oder mikrorauhe Trägerpartikel enthält, an die die Schwermetallkeime gebunden sind. Bei der Metallisierung wird durch das in die Poren hineinwachsende Kupfer eine feste Verwurzelung erreicht und damit eine optimale Haftung der aufgebrachten Leiterzüge auf dem Schaltungsträger gewährleistet.

Die Zugänglichkeit der haftvermittelnden Mikroporen wird außerdem dadurch erhöht, daß das Trägermaterial aus einer Polymermatrix mit eingebetteten mikroporösen oder mikrorauhen Trägerpartikeln für die Schwermetallkeime besteht, die durch die aufgebrachte UV-Strahlung zwar an der Oberfläche durch Ablation des Polymeren freigelegt, selbst aber durch die UV-Strahlung nicht abgebaut werden. Danach kann das Werkstück direkt chemisch reduktiv metallisiert werden Erfindungsgemäß wird somit mit doppelter Wirkung aktiviert, indem einerseits die zur Metallhaftung erforderlichen Mikroporen bzw. Mikrorauhigkeiten freigelegt und andererseits eben dort auch die erforderlichen Schwermetallkeime durch Aufbrechen des organischen, nichtleitenden Schwermetallkomplexes freigesetzt werden.

Indem gemäß dem erfindungsgemäßen Verfahren als schwermetallhaltige Komponente ein organischer nichtleitender Schwermetallkomplex an mikroporöse Trägerpartikel angebunden wird, die Trägerpartikel im Bereich der zu erzeugenden Leiterbahnstrukturen in das Trägermaterial eingemischt und/oder auf das Trägermaterial aufgebracht und angebunden werden werden, auf das Trägermaterial eine elektromagnetische UV-Strahlung im Bereich der zu erzeugenden Leiterbahnstrukturen selektiv aufgebracht wird, derart, daß Trägerpartikel durch Abtrag freigelegt und durch ein Aufbrechen des angebundenen Schwermetallkomplexes Schwermetallkeime freigesetzt werden und dieser Bereich zur Ausbildung der Leiterbahnstrukturen anschließend chemisch-reduktiv metallisiert wird, werden einerseits die zur Metallhaftung erforderlichen Mikroporen bzw. Mikrorauhigkeiten freigelegt und andererseits eben dort auch die erforderlichen Schwermetallkeime durch Aufbrechen des organischen, nichtleitenden Schwermetallkomplexes freigesetzt.

Von Vorteil ist es, daß nach der Einwirkung der elektromagnetischen UV-Strahlung direkt anschließend die chemisch reduktive Metallisierung erfolgen kann. Ein durchaus problematischer Spülprozeß ist nicht erforderlich. Im Bereich der zu erzeugenden Leiterbahnstrukturen erfolgt durch die Einwirkung der UV-Strahlung ein Aufbrechen des Schwermetallkomplexes, wodurch für die partielle reduktive Metallisierung hochreaktive Schwermetallkeime abgespalten werden. Die Metallisierung erfolgt dennoch ohne jeden Wildwuchs unter Ausbildung sehr scharfer Konturen. Da die gebildeten Schwermetallkeime hochreaktiv sind, wird die erwünschte exakte Metallisierung in der erforderlichen Schichtdicke zusätzlich begünstigt.

Im Rahmen der Erfindung ist es vorgesehen, daß eine elektromagnetische Strahlung eines UV-Lasers, eines Excimer-Lasers oder eines UV-Strahlers eingesetzt wird. Gemäß einer bevorzugten Ausführungsform der Erfindung wird zur Freilegung der mikroporösen Füllstoffpartikel und zur Abspaltung der Schwermetallkeime ein KrF-Excimerlaser mit einer Wellenlänge von 248 nm eingesetzt.

Vorzugsweise wird ein Pd-Komplex bzw. ein Pd-haltiger Schwermetallkomplex verwendet. Wie sich gezeigt hat, sind derartige Schwermetallkomplexe besonders gut zur Feinststrukturierung gemäß dem erfindungsgemäßen Verfahren geeignet. Insbesondere ist für die Einleitung der strukturierenden Spaltungsreaktion eine UV-Strahlung einer wesentlich geringeren Energiedichte ausreichend, als für das Abtragen bzw. auch für das Auslösen des als Zersetzung beschriebenen Wirkungsmechanismus bei bekannten Systemen. Zusätzlich wird erreicht, daß im Zusammenhang mit der Strukturierung pro Laserimpuls wesentlich größere Flächen belichtet werden können als bei bekannten Ablationstechniken.

Im Rahmen der Erfindung ist es außerdem vorgesehen, daß zur Abspaltung der Schwermetallkeime aus dem Schwermetallkomplex vorzugsweise ein Kr F-Excimerlaser mit einer Wellenlänge von 248 nm eingesetzt wird. Es ist so möglich, die Abspaltung ohne Aufheizung des Komplexes durchzuführen. Hierdurch wird ein Aufschmelzen von Materialien im Einwirkungsbereich vermieden. Die Folge ist eine sehr hohe Begrenzungsschärfe der Bereiche mit abgespalteten Schwermetallkeimen und sich daraus ergebend eine sehr hohe, äußerst vorteilhafte Kantenschärfe der metallisierten Strukturen, was insbesondere bei Feinstleitern von großer Bedeutung ist.

Gemäß einer bevorzugten Ausführungsform ist es außerdem vorgesehen, daß Palladiumdiacetat mit einem organischen Komplexbildner zu einem Pd-Komplex umgesetzt wird. Wie sich gezeigt hat, ist es vorteilhaft, wenn als organischer Komplexbildner ein an sich bekannter, hochstabiler polyfunktioneller Chelatbildner mit mehreren Ligandenatomen, wie N, O, S, P eingesetzt wird. Im Rahmen der Erfindung ist es weiterhin vorgesehen, daß der polyfunktionelle Chelatbildner auch zusammen mit ionisierenden Gruppen, wie Hydroxyl- oder Carboxylgruppen, eingesetzt werden kann.

Insbesondere können als organische Komplexbildner molekulare Kombinationen von sterisch gehinderten Aromaten und metallkomplexierenden Gruppen eingesetzt werden. Vorzugsweise findet dabei ein organischer Komplexbildner der Formel 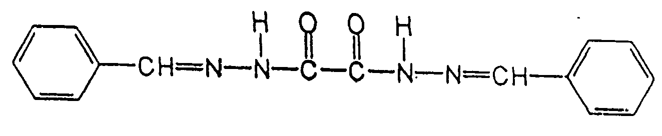 Verwendung.

Vorteilhaft ist es, wenn gegen elektromagnetische UV-Strahlung resistente Trägerpartikel als Träger für den Schwermetallkomplex eingesetzt werden. Hierbei handelt es sich bevorzugt um anorganisch-mineralische Trägerpartikel, die von pyrogener Kieselsäure oder von Aerogelen gebildet sind.

Gemäß bevorzugter Ausführungsformen der Erfindung sind die Trägerpartikel von pyrogener Kieselsäure mit einer BET-Oberfläche von 200 m²/g oder von Aerogelen gebildet.

Im Rahmen der Erfindung ist es weiterhin vorgesehen, daß das Anbinden des Schwermetallkomplexes an die Trägerpartikel durch Tränken in einer Lösung des Schwermetallkomplexes erfolgt. Die so präparierten Trägerpartikel werden dann in den Polymerwerkstoff eingemischt, aus denen die Schaltungsträger gespritzt werden. Alternativ ist es vorgesehen, daß die Trägerpartikel mit dem Schwermetallkomplex in ein Bindemittel, insbesondere einen Lack eingemischt und dann als Beschichtung auf das Trägermaterial aufgebracht werden.

Das erfindungsgemäße Verfahren kann sowohl mit flächig aufgebrachter Laserstrahlung und Maskentechnik in einer rationellen Massenfertigung eingesetzt werden, als auch maskenlos über eine beispielsweise NC-gesteuerte Führung eines punktförmig fokussierten Laser-strahls zur Prototypen- oder Kleinserienfertigung Anwendung finden.

Im folgenden wird die Erfindung an einem Ausführungsbeispiel erläutert:

Es werden 2,24 Masseteile Palladiumdiacetat in 100 Masseteilen Dimethylformamid gelöst. Außerdem werden 2,94 Masseteile des organischen Komplexbildners der Formel

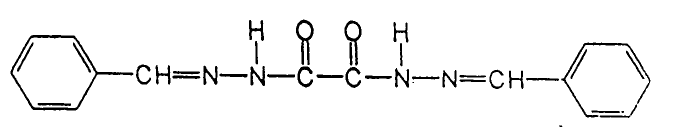

in 800 Masseteile Dimethylformamid eingebracht und durch Erwärmen gelöst. Beide Lösungen werden dann gemischt und zur Reaktion gebracht. Unmittelbar danach, bevor die Lösung abkühlt und der entstandene Palladiumkomplex ausfällt, werden Trägerpartikel, die aus einer pyrogenen Kieselsäure bestehen, die unter der Bezeichnung "Aerosil 200" erhältlich ist, in der Lösung getränkt. Nach einem Trocknungs- und Mahlvorgang werden die Trägerpartikel nach einem gebräuchlichen Aufbereitungsverfahren in einen Polymerpulveransatz in einem Anteil von bis zu 50% eingemischt. Nach der Agglomerierung des Materials im Heißmischer erfolgt in einem Granulator eine Granulierung des Materials. Das Kunststoffgranulat enthält nun die erforderliche Menge des organischen Schwermetallkomplexes in der Porenstruktur der eingearbeiteten Trägerpartikel. Das Granulat wird dann mittels der Spritzgießtechnik zu dreidimensionalen Schaltungsträgern verarbeitet.

Die Schaltungsträger werden anschließend mittels einer Excimerlaser-UV-Strahlung mit einer Wellenlänge von 248 nm, über eine Maske bestrahlt. In den bestrahlten Bereichen werden dabei die Trägerpartikel durch Ablation der sie umgebenden Polymermatrix freigelegt und gleichzeitig an und in den Poren der Trägerpartikel feinstverteiltes metallisches Palladium aus dem Schwermetallkomplex abgespalten. In einem handelsüblichen reduktiven, außenstromlosen Kupferbad scheidet sich selektiv in den bestrahlten Bereichen sehr haftfest verankertes Kupfer ab. Die Leiterzüge sind ausgebildet, es liegt ein einsatzfähiger Schaltungsträger vor.

Alternativ ist es auch möglich, als Trägerpartikel Aerogele einzusetzen. Die hochporösen Festkörper aus SiO2 mit einer BET-Oberfläche von bis zu 1000 m²/g ermöglichen eine noch festere Anbindung der metallischen Leiterbahnen an den Schaltungsträger.

## Patentansprüche

1. Verfahren zur Herstellung von Leiterbahnstrukturen auf einem nichtleitenden Trägermaterial, insbesondere feine Leiterbahnstrukturen, die aus einer schwermetallhaltigen Basis und einer auf diese aufgebrachten Metallisierungsschicht bestehen, wobei die schwermetallhaltige Basis im Bereich der Leiterbahnstrukturen Schwermetallkeime enthält, die durch Aufbrechen eines organischen nichtleitenden Schwermetallkomplexes entstanden sind und daß das Trägermaterial mikroporöse oder mikrorauhe Trägerpartikel enthält, an die die Schwermetallkeime gebunden sind, wobei eine schwermetallhaltige Komponente auf ein nichtleitendes Trägermaterial aufgebracht wird, im Bereich der zu erzeugenden Leiterbahnstrukturen eine elektromagnetische Strahlung im UV-Bereich selektiv aufgebracht wird, wobei Schwermetallkeime freigesetzt werden und dieser Bereich chemisch reduktiv metallisiert wird, **dadurch gekennzeichnet, daß**
- als schwermetallhaltige Komponente ein organischer nichtleitender Schwermetallkomplex an mikroporöse oder mikrorauhe Trägerpartikel angebunden wird,
- die Trägerpartikel im Bereich der zu erzeugenden Leiterbahnstrukturen in das Trägermaterial eingemischt und/oder auf das Trägermaterial aufgebracht und angebunden werden werden,
- auf das Trägermaterial eine elektromagnetische UV-Strahlung im Bereich der zu erzeugenden Leiterbahnstrukturen selektiv aufgebracht wird, derart, daß Trägerpartikel durch Abtrag freigelegt und durch ein Aufbrechen des angebundenen Schwermetallkomplexes Schwermetallkeime freigesetzt werden,
- dieser Bereich zur Ausbildung der Leiterbahnstrukturen anschließend chemisch-reduktiv metallisiert wird.

2. Verfahren nach Anspruch 1, **dadurch gekennzeichnet, daß** eine elektromagnetische Strahlung eines UV-Lasers, eines Excimer-Lasers oder eines UV-Strahlers eingesetzt wird.

3. Verfahren nach Anspruch 1, **dadurch gekennzeichnet, daß** zur Freilegung der mikroporösen Füllstoffpartikel und zur Abspaltung der Schwermetallkeime ein KrF-Excimerlaser mit einer Wellenlänge von 248 nm eingesetzt wird.

4. Verfahren nach Anspruch 1 und einem oder mehreren der weiteren Ansprüche, **dadurch gekennzeichnet, daß** ein Pd-haltiger Schwermetallkomplex verwendet wird.

5. Verfahren nach Anspruch 4, **dadurch gekennzeichnet, daß** ein Pd-Komplex verwendet wird.

6. Verfahren nach Anspruch 5, **dadurch gekennzeichnet, daß** der Pd-Komplex gebildet wird, indem ein Palladiumsalz mit einem organischen Komplexbildner umgesetzt wird.

7. Verfahren nach Anspruch 1, **dadurch gekennzeichnet, daß** der Pd-Komplex gebildet wird, indem Palladiumdiacetat mit einem organischen Komplexbildner umgesetzt und auskristallisiert wird.

8. Verfahren nach Anspruch 7, **dadurch gekennzeichnet, daß** als organischer Komplexbildner ein hochstabiler polyfunktioneller Chelatbildner mit mehrereren Ligandenatomen, wie N, O, S, P allein oder zusammen mit ionisierenden Gruppen, wie Hydroxyl- oder Carboxylgruppen, eingesetzt wird.

9. Verfahren nach den Ansprüchen 7 und 8, **dadurch gekennzeichnet, daß** als organischer Komplexbildner molekulare Kombinationen von sterisch gehinderten Aromaten und metallkomplexierenden Gruppen eingesetzt werden.

10. Verfahren nach den Ansprüchen 7, 8 und 9, **dadurch gekennzeichnet, daß** ein organischer Komplexbildner der Formel 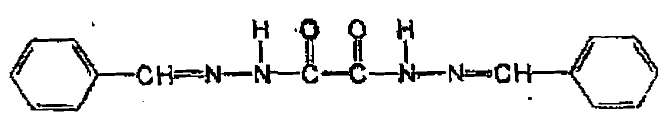 eingesetzt wird.

11. Verfahren nach Anspruch 1 und einem oder mehreren der weiteren Ansprüche, **dadurch gekennzeichnet, daß** gegen UV-Strahlung resistente Trägerpartikel eingesetzt werden.

12. Verfahren nach Anspruch 1 und einem oder mehreren der weiteren Ansprüche, **dadurch gekennzeichnet, daß** anorganisch-mineralische Trägerpartikel eingesetzt werden.

13. Verfahren nach Anspruch 12, **dadurch gekennzeichnet, daß** die Trägerpartikel von pyrogener Kieselsäure oder von Aerogelen gebildet sind.

14. Verfahren nach Anspruch 13, **dadurch gekennzeichnet, daß** die Trägerpartikel von pyrogener Kieselsäure mit einer BET-Oberfläche von 200 m²/g gebildet sind.

15. Verfahren nach Anspruch 13, **dadurch gekennzeichnet, daß** die Trägerpartikel von Aerogelen gebildet sind.

16. Verfahren nach Anspruch 1 und einem oder mehreren der weiteren Ansprüche, **dadurch gekennzeichnet, daß** das Anbinden des Schwermetallkomplexes an die Füllstoffpartikel durch Tränken in einer Lösung des Schwermetallkomplexes erfolgt.

17. Verfahren nach Anspruch 1 und einem oder mehreren der weiteren Ansprüche, **dadurch gekennzeichnet, daß** die Trägerpartikel mit dem Schwermetallkomplex in ein Bindemittel, insbesondere einen Lack eingemischt und dann als Beschichtung auf das Trägermaterial aufgebracht werden.

## Claims

1. Process for the production of conductor track structures on a non-conductive substrate, in particular fine conductor track structures consisting of a base containing heavy metal and a metal coated layer applied thereto, the base containing heavy metals comprising in the region of the conductor track structures heavy metal nuclei produced by breaking up an organic non-conductive heavy metal complex and the substrate containing microporous or micro-coarse substrate particles to which the heavy metal nuclei are bound, a component containing heavy metal being applied to a non-conductive substrate, electromagnetic radiation in the UV range being applied selectively in the region of the conductor track structures to be produced, heavy metal nuclei being released and this region being metal coated by chemical reduction, **characterised in that**
- an organic non-conductive heavy metal complex as the component containing heavy metal is bound to microporous or micro-coarse substrate particles,
- the substrate particles are mixed into the substrate in the region of the conductor track structures to be produced and/or are applied and bound to the substrate,
- electromagnetic UV radiation is selectively applied to the substrate in the region of the conductor track structures to be produced in such a way that substrate particles are exposed by a removal process and heavy metal nuclei are released by breaking up the heavy metal complex bound thereto,
- this region is subsequently metal coated by chemical reduction to form the conductor track structures.

2. Process according to claim 1, **characterised in that** an electromagnetic radiation of a UV laser, an excimer laser or a UV radiator is used.

3. Process according to claim 1, **characterised in that** a KrF excimer laser with a wavelength of 248 mn is used to expose the microporous filler particles and to split off the heavy metal nuclei.

4. Process according to claim 1 and one or more of the other claims, **characterised in that** a heavy metal complex containing Pd is used.

5. Process according to claim 4, **characterised in that** a Pd complex is used.

6. Process according to claim 5, **characterised in that** the Pd complex is formed by reacting a palladium salt with an organic complex former.

7. Process according to claim 1, **characterised in that** the Pd complex is formed by reacting palladium diacetate with an organic complex former and crystallising the reaction mixture.

8. Process according to claim 7, **characterised in that** the organic complex former is a highly stable polyfunctional chelate former with a plurality of ligand atoms, such as N, O, S, P, singly or together with ionising groups such as hydroxyl or carboxyl groups.

9. Process according to claims 7 and 8, **characterised in that** molecular combinations of sterically hindered aromatics and metal-complexing groups are used as the organic complex former.

10. Process according to claims 7, 8 and 9, **characterised in that** an organic complex former of formula 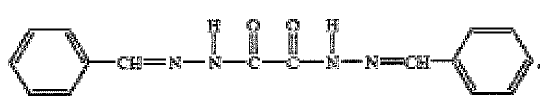 is used.

11. Process according to claim 1 and one or more of the other claims, **characterised in that** substrate particles which are resistant to UV radiation are used.

12. Process according to claim 1 and one or more of the other claims, **characterised in that** inorganic mineral substrate particles are used.

13. Process according to claim 12, **characterised in that** the substrate particles are formed of pyrogenic silica or of aerogels.

14. Process according to claim 13, **characterised in that** the substrate particles are formed of pyrogenic silica having a BET surface of 200 m²/g.

15. Process according to claim 13, **characterised in that** the substrate particles are formed of aerogels.

16. Process according to claim 1 and one or more of the other claims, **characterised in that** the heavy metal complex is bound to the filler particles by soaking in a solution of the heavy metal complex.

17. Process according to claim 1 and to one or more of the other claims, **characterised in that** the substrate particles are mixed with the heavy metal complex into a binder, in particular a lacquer, and are then applied as a coating to the substrate.

## Revendications

1. Procédé de réalisation de structures de pistes conductrices sur un matériau support non conducteur, en particulier de fines structures de pistes conductrices, qui sont formées par une base contenant des métaux lourds et une couche de métallisation appliquée sur celle-ci, sachant que la base qui contient des métaux lourds comporte dans la zone des structures de pistes conductrices des germes de métaux lourds, qui ont été formés par la dissociation d'un complexe de métaux lourds organique non conducteur et le matériau support contenant des particules support microporeuses ou micro-rugueuses, sur lesquelles sont liés les germes de métaux lourds, un composant contenant des métaux lourds étant déposé sur un matériau support non conducteur, un rayonnement électromagnétique dans le domaine de l'ultraviolet étant appliqué de manière sélective dans la zone des structures de pistes conductrices à réaliser, des germes de métaux lourds étant mis à nu et cette zone étant métallisée par réduction chimique, **caractérisé en ce que**
- un complexe de métaux lourds organique non conducteur est lié à des particules microporeuses ou micro-rugueuses pour former le composant contenant des métaux lourds,
- les particules support sont ajoutées au matériau support dans la zone des structures de pistes conductrices à réaliser et/ou sont appliquées sur le matériau support et liées,
- un rayonnement ultraviolet électromagnétique est appliqué de manière sélective sur le matériau support dans la zone des structures de pistes conductrices, de telle sorte que les particules support sont mises à nu par érosion et les germes de métaux lourds sont mis à nu par une dissociation du complexe de métaux lourds lié,
- cette zone est métallisée ensuite par réduction chimique pour la réalisation des structures de pistes conductrices.

2. Procédé selon la revendication 1, **caractérisé en ce qu'**il est utilisé un rayonnement électromagnétique d'un laser UV, d'un laser à excimère, ou un rayonnement ultraviolet.

3. Procédé selon la revendication 1, **caractérisé en ce que**, pour la mise à nu des particules de matière de remplissage microporeuses et pour la dissociation des germes de métaux lourds, on utilise un laser à excimère KrF avec une longueur d'onde de 248 nm.

4. Procédé selon la revendication 1 et une ou plusieurs des autres revendications, **caractérisé en ce que** l'on utilise un complexe de métaux lourds contenant du palladium.

5. Procédé selon la revendication 4, **caractérisé en ce que** l'on utilise un complexe de palladium.

6. Procédé selon la revendication 5, **caractérisé en ce que** le complexe de palladium est formé du fait qu'un sel de palladium est transformé avec un agent complexant organique.

7. Procédé selon la revendication 1, **caractérisé en ce que** le complexe de palladium est formé du fait qu'un acétate de palladium est transformé avec un agent complexant organique.

8. Procédé selon la revendication 7, **caractérisé en ce que** l'agent complexant organique utilisé est un agent chélateur polyfonctionnel, très stable, avec plusieurs atomes du type ligand, tels que N, O, S, P isolément ou combinés avec des groupes ionisants, tels que les groupes hydroxyles ou carboxyles.

9. Procédé selon les revendications 7 et 8, **caractérisé en ce que** des combinaisons moléculaires d'aromates à empêchement stérique et des groupes complexants métalliques sont utilisés pour former l'agent complexant organique.

10. Procédé selon les revendications 7, 8 et 9, **caractérisé en ce que** l'on utilise un agent complexant organique selon la formule :

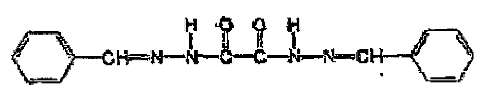

11. Procédé selon la revendication 1 et une ou plusieurs des autres revendications, **caractérisé en ce que** l'on utilise des particules support résistantes au rayonnement UV.

12. Procédé selon la revendication 1 et une ou plusieurs des autres revendications, **caractérisé en ce que** l'on utilise des particules support anorganiques minérales.

13. Procédé selon la revendication 12, **caractérisé en ce que** les particules support sont formées par un acide silicique pyrogéné ou par des aérogels.

14. Procédé selon la revendication 13, **caractérisé en ce que** les particules support sont formées par un acide silicique pyrogéné avec une surface BET de 200 m²/g.

15. Procédé selon la revendication 13, **caractérisé en ce que** les particules support sont formées pas des aérogels.

16. Procédé selon la revendication 1 et une ou plusieurs des autres revendications, **caractérisé en ce que** la liaison du complexe de métaux lourds avec les particules de matière de remplissage est effectuée par imprégnation dans une solution du complexe de métaux lourds.

17. Procédé selon la revendication 1 et une ou plusieurs des autres revendications, **caractérisé en ce que** les particules support avec le complexe de métaux lourds sont ajoutées dans un liant, en particulier un vernis, et sont appliquées ensuite comme revêtement sur le matériau support.
